# EUROPÄISCHE PATENTSCHRIFT

(11) **EP 0 323 579 B1**
(45) Veröffentlichungstag und Bekanntmachung des Hinweises auf die Patenterteilung: **19.03.1997**
(21) Anmeldenummer: 88120504.1
(22) Anmeldetag: 08.12.1988
(51) Int. Cl.: H05K 7/14, G05B 19/04

(54) **Dezentrale Ein/Ausgabebaugruppe für elektronische Steuerungen**
Decentralised input/output assembly for electronic controls
Unité d'entrée/sortie décentralisée pour commandes électroniques

(30) Priorität: 05.01.1988 DE 3800077
(43) Veröffentlichungstag der Anmeldung: 12.07.1989
(73) Patentinhaber: ROBERT BOSCH GMBH, 70442 Stuttgart (DE)
(72) Erfinder: Eckart, Götz, Dipl.-Ing., D-6120 Erbach (DE); Lerch, Hans-Peter, Dr.-Ing., D-6120 Erbach (DE); Dörsam, Thomas, Dipl.-Ing., D-6943 Birkenau (DE); Schweigert, Gerhard, Dipl.-Ing., D-6100 Darmstadt (DE); Wittmann, Werner, Dipl.-Ing., D-6120 Erbach (DE); Korner, Michael, Dipl.-Ing., D-6107 Reinheim (DE)

(56) Entgegenhaltungen:
- EP-A- 0 171 687
- EP-A- 0 236 711
- DE-A- 3 440 025
- GB-A- 2 159 981
- GB-A- 2 159 987

## Beschreibung

Die Erfindung betrifft eine dezentrale Ein/Ausgabebaugruppe für elektronische Steuerungen der im Oberbegriff des Anspruches 1 angegebenen Art.

Ein/Ausgabebaugruppen sind aus EP-A-0 236 711 bekannt.

Zur Steuerung größerer Maschinen oder Anlagen wird die Verbindung einer Vielzahl von Melde-, Stell- und Meßglieder mit der elektronischen Steuerung erforderlich, die üblicherweise nicht in unmittelbarer Nähe dieser Glieder angeordnet ist. Um nicht jede dieser Verbindungen getrennt über Leitungen bis zur Steuerung führen zu müssen, ist es bekannt (z. B. DE-OS 35 19 807) in unmittelbarer Nähe der Maschine oder des entsprechenden Anlageteils ein oder mehrere elektronische Ein/ Ausgabesysteme vorzusehen, die über einen Datenbus mit der Steuerung verbunden sind, der Signale in beide Richtungen überträgt. Im allgemeinen wird hierbei die elektronische Steuerung außerhalb des Einflußbereiches von an der Maschine oder Anlage entstehenden Stäuben, Spänen und/oder Flüssigkeiten angeordnet. Das Ein/Ausgabesystem ist häufig jedoch diesen Einflüssen ausgesetzt und/oder es muß an nicht leicht zugänglicher Stelle angeordnet werden.

Das Ein/Ausgabesystem muß daher in einem Gehäuse untergebracht werden, das staub- und/oder wasserdicht ausgebildet ist. in dieses Gehäuse werden dann die große Zahl der Verbindungen zu den Melde-, Stell-, Meßgliedern und die Stromversorgung für das Ein/Ausgabesystem geführt. Ein Gehäuse, das gegen Eindrigen von Staub und Feuchtigkeit geschützt ist, ist in EP-A-0 623 534 offenbart. Da alle diese an oder in der Maschine oder Anlage verteilt angeordneten Ausrüstungsteile üblicherweise harten Umweltbedingungen ausgesetzt sind, treten an diesen die häufigsten Fehler auf. Um diese Fehler rechtzeitig erkennen und lokalisieren zu können, ist es erforderlich (z. B. DE-OS 35 19 862 und DE-OS 34 40 025), Schaltungen vorzusehen, die eine Überwachung aller dieser Verbindungen und/oder das Arbeiten der Melde-, Stell- und Meßglieder ermöglichen. Bei einer Störung wird dann üblicherweise die Fehlerquelle und zum Teil auch die Fehlerart wie Unterbrechung, Kurzschluß oder falsches Arbeiten angezeigt.

Trotz dieser Hilfen wird die eigentliche Fehlerbeseitigung in vielen Fällen schwierig, da der Fehlerort nicht eindeutig zu ermitteln ist und der Ersatz einzelner Melde-, Stell- oder Meßglieder bzw. deren Verbindung zum Ein/Ausgabesystem nicht nur arbeitsaufwendig ist, sondern nur von einer gesondert geschulten Fachkraft ausgeführt werden kann. Dies trifft vor allem dann zu, wenn eine Fehlersuche oder Fehlerbeseitigung im Ein/Ausgabesystem durchgeführt wird, oder ein Melde-, Stell- oder Meßglied mit der Zuleitung zu diesem System ersetzt werden muß.

Es ist Aufgabe der Erfindung, die Fehlerbeseitigung und/oder Fehlersuche zu erleichtern und zu vereinfachen. Eine weitere Aufgabe ist es, ein Ein/Ausgabesystem zu schaffen, das sich leicht an sehr unterschiedlich aufgebaute Maschinen oder Anlageteile anpassen läßt. Möglich wird dies mit einer Ein/Ausgangsbaugruppe entsprechend dem kennzeichnendem Teil des Anspruches 1.

Durch den steckbaren Aufbau lassen sich erhebliche Vorteile erzielen, die sowohl den modularen Aufbau, die Fehlersuche, die Fehlerbeseitigung und die Anordnung an der Maschine bzw. des Anlageteils betreffen. Durch die staub- und/oder wasserdichte Ausbildung wird es möglich, einzelne Teile der Ein/Ausgabebaugruppe ohne ein zusätzliches Gehäuse direkt zugänglich zu machen, wobei ein Auswechseln einzelner Bausteine sehr einfach wird und ohne großen Zeitaufwand erfolgen kann.

Wird zum Beispiel ein Fehler zu einem der Melde-, Stell- oder Meßglieder angezeigt, kann durch Ziehen des entsprechend gekennzeichneten Steckers der Fehler leicht nachgeprüft werden und das defekte Teil zusammen mit der Zuleitung auch von einer nicht besonders geschulten Fachkraft ausgetauscht werden. Dies gilt vor allem für solche Melde-, Stell- oder Meßglieder, die wegen der harten Umweltbedingungen total abgedichtet, z. B. mit den Anschlüssen oder dem Anschlußkabel vergossen sind. So kann durch eine rasche Fehlerbeseitigung, eventuell auch durch den entsprechend eingewiesenen Bedienungsmann, die Ausfallzeit der Maschine oder Anlage wesentlich herabgesetzt werden.

Durch das Einstecken weiterer oder anderer Ein/Ausgangsmodule wird weiterhin eine einfache Anpassung der Steuerung an die Maschine oder Anlage möglich. Weitere Vorteile ergeben sich durch eine Ausbildung der Ein/Ausgabebaugruppe mit den Merkmalen der Unteransprüche, die in der Beschreibung näher erläutert sind.

Ausführungsbeispiele der Erfindung sind in den Zeichnungen dargestellt und in der nachfolgenden Beschreibung näher erläutert. Es zeigen:
Fig. 1 eine Ein/Ausgabebaugruppe in der Draufsicht
Fig. 2 die Ein/Ausgabebaugruppe gemäß Fig. 1 in einer Seitenansicht
Fig. 3 einen Steckverteilerkasten im Schnitt
Fig. 4 ein Ein/Ausgangsmodul im Schnitt und
Fig. 5 das Ein/Ausgangsmodul gemäß Fig. 4 in der Draufsicht

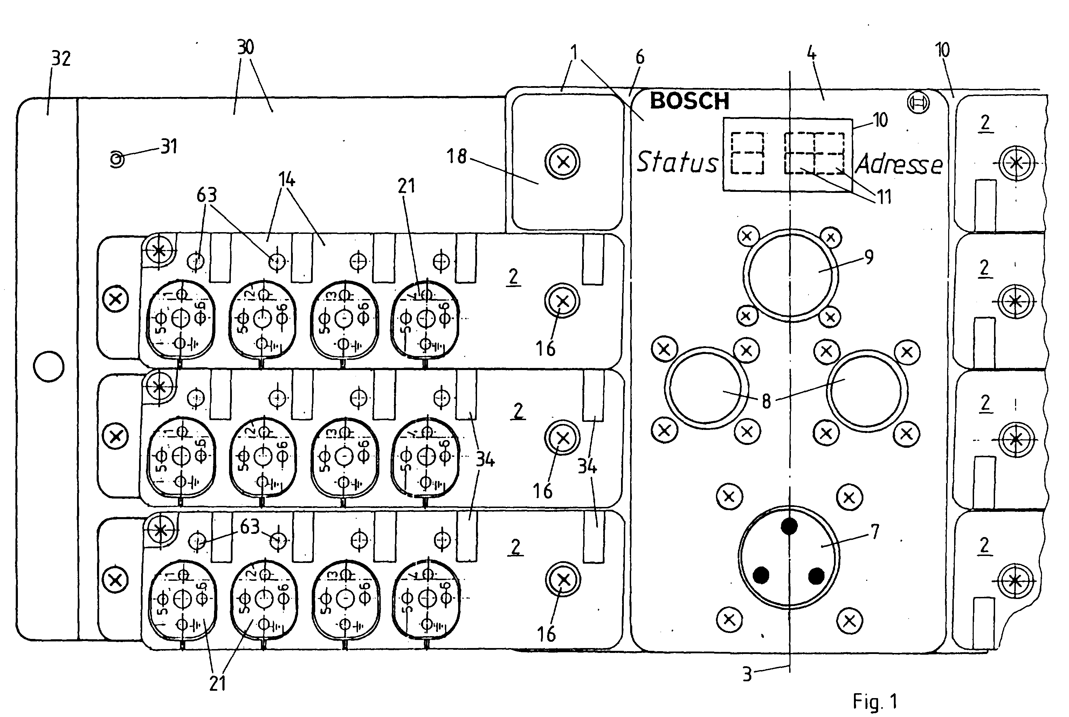

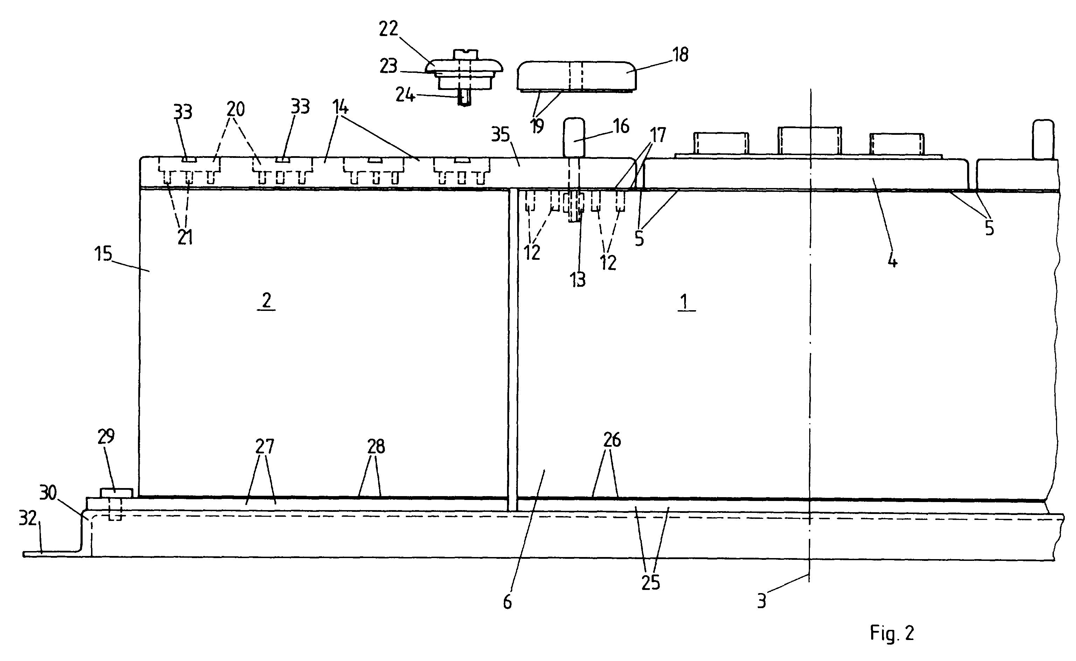

Fig. 1 und 2 zeigt eine Ein/Ausgabebaugruppe mit einem Steckverteilerkasten 1 in der Mitte und einsteckbare Ein/Ausgangsmodule 2 die spiegelbildlich um eine Mittellinie 3 auf beiden Seiten des Steckverteilkastens 1 leicht austauschbar befestigt werden können. Der Steckverteilerkasten 1 weist eine obere Abdeckplatte 4 auf, die abgedichtet durch eine dazwischenliegende Dichtung 5 mit einem Gehäuse 6 verschraubt ist. Im unteren Teil der Abdeckplatte ist ein dreipoliger Steckanschluß 7 für die Stromversorgung des im Steckverteilerkasten 1 angeordneten Logikbausteins sowie der Ein/Ausgangsmodule über deren Steckverbindungen , im mittleren Teil zwei weitere Steckanschlüsse 8 für den Bus und ein vielpoliger Steckanschluß 9 für ein Diagnosegerät vorgesehen. Zu diesen Steckanschlüssen werden wasserdichte, verschraubbare Stecker (nicht dargestellt) geführt, oder wenn kein Anschluß erfolgt, insbesondere für den Anschluß des Diagnosegerätes die freien Steckeranschlüsse mit einer entsprechenden Verschlußkappe abgedichtet. Im oberen Teil ist ein Durchbruch 10 für eine Anzeigeeinrichtung 11 vorgesehen, die z. B. die Adresse der Ein- oder Ausgangsstufe und den zugehörenden Status anzeigt. Der Durchbruch 10 ist mit einem Schauglas wasserdicht abgeschlossen.

Auf beiden Seiten der Abdeckplatte 4 sind jeweils vier, in einer Reihe angeordnete, mehrpolige Steckbuchsen 12 vorgesehen, die jeweils in ihrer Mitte ein Schraubgewinde 13 aufweisen. In diese Steckbuchsen lassen sich auf beiden Seiten je vier Ein/Ausgangsmodule 2 einstecken. Die Stecker hierzu sind auf der Unterseite einer Verlängerung 35 angebracht, die seitlich aus der Schmalseite der Gehäuse 15 der Ein/Ausgangsmodule 2 herausragt und durch eine obere Abdeckung 14 für das Gehäuse 15 abgedeckt ist. Durch die Mitte dieser Verlängerung 35 ist eine unverlierbar gehalterte Schraube 16 mit Rändelkopf geführt, die Teil der Befestigung der Ein/Ausgangsmodule 2 ist. Bei einem Anziehen dieser Schraube 16 wird der Teil der Verlängerung 35, der die Stecker 12 umgibt, auf eine Dichtung 17 gepreßt, die Teil der Dichtung 5 für die Abdeckplatte 4 sein kann.

Bleibt ein Anschluß für ein Ein/Ausgangsmodul 2 ungenutzt, wird dieser mit einer Blindkappe 18 abgedeckt. Diese Blindkappe kann mit einem um die Steckbuchsen und die Schraubbefestigung herumgeführten Einpreßwulst 19 versehen sein, der einen wasserdichten Verschluß ermöglicht. Ein gleichartiger Wulst kann auch an der entsprechenden Stelle an der Unterseite der Verlängerung 35 für die Ein/Ausgangsmodule angebracht sein.

Jede Abdeckplatte 14 der Ein/Ausgangsmodule 2 enthält in Vertiefungen 20 vier in Reihe angeordnete Steckbuchsen 21 in die Stecker (nicht dargestellt) für die Melde-, Stell- oder Meßglieder einsteckbar sind, und im Innern mit den Ein/Ausgangsstufen dieser Module verbunden sind. Bleibt ein Anschluß ungenutzt, wird auch dieser mit einer Kappe 22 verschlossen, wobei z. B. mit einem Gummi-O-Ring 23 ein wasserdichter Verschluß erfolgt, wenn die Kappe mit einer Schraube 24 angezogen wird. In ähnlicher Weise kann auch die Abdichtung der Stecker für die Steckbuchsen 21 bewirkt werden. Am Gehäuseboden des Steckverteilerkastens 1 ist eine dem Gehäuseboden angepaßte Kühlplatte 25 montiert, die wärmeleitend mit den im Innern vorgesehenen Leistungsteilen wie z. B. Leistungstransistoren in Verbindung steht. Die hierzu erforderlichen Durchbrüche durch den Gehäuseboden sind durch eine weitere Dichtung 26 abgedichtet. In ähnlicher Weise ist der Gehäuseboden der Ein/Ausgangsmodule mit einer Kühlplatte 27 und einer Abdichtung 28 versehen. Diese Kühlplatte ragt auf der äußeren Schmalseite so weit über den Gehäuseboden hinaus, daß dort eine Befestigungsschraube 29 Platz findet, die von oben leicht zu erreichen ist. Hierdurch wird eine einfache Montage bzw. Auswechseln eines Ein/Ausgangsmoduls 2 über die beiden Schraubbefestigungen (16, 29) möglich.

Zur leichteren Montage der kompletten Ein/Ausgabebaugruppe ist das Gehäuse 6 des Steckverteilerkastens 1 und alle Ein/Ausgangsmodule 2 auf einem Montagerahmen 30 montiert. Dieser Montagerahmen 30 weist Gewindebohrungen 31 zur äußeren Befestigung der Ein/Ausgangsmodule 2 und unter dem Gehäuse 6 des Steckverteilerkastens 1 Durchbrüche auf, mit denen das Gehäuse 6 von unten auf dem Montagerahmen befestigt ist. An beiden Seiten des Montagerahmens ragen Befestigungsflächen 32 heraus, mit denen der Montagerahmen an der Maschine oder einem Anlageteil befestigt werden kann. Diese Befestigung kann mit jeweils einer Befestigungsschraube auf jeder Seite erfolgen oder falls erforderlich, über eine schwingungsdämpfende und/oder isolierende Befestigung an allen vier Ecken bewirkt werden, wenn am Befestigungsort harte Schwingungen zu erwarten sind, oder durch eine elektrisch leitende Verbindung z. B. über Schutzleiterverbindungen sich eine Verbindungsschleife ergibt über die Störimpulse eingeschleppt werden können.

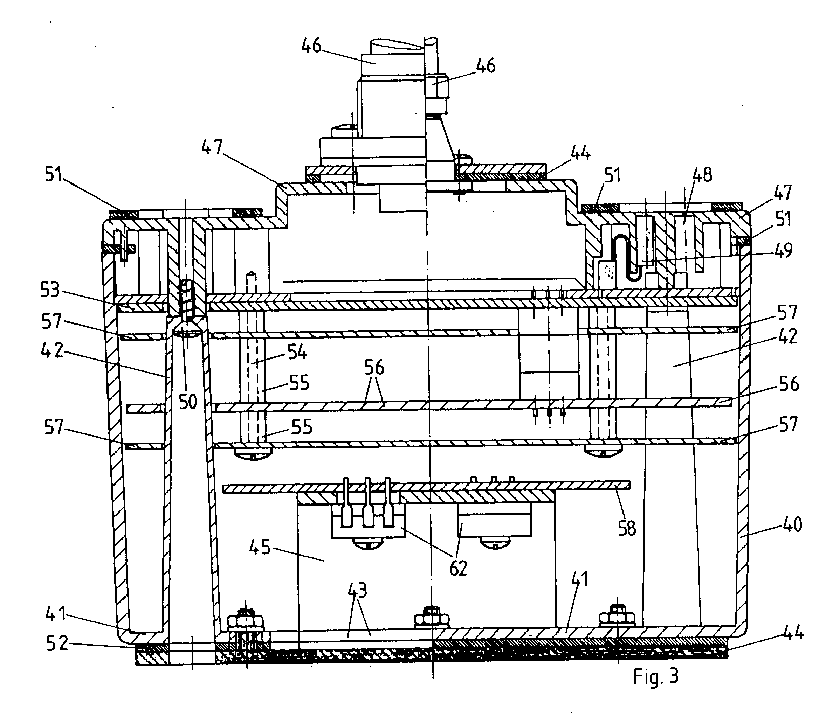

In Fig. 3 ist ein Steckverteilerkasten (1) an unterschiedlichen Stellen geschnitten dargestellt. Das Gehäuse 40 besteht hier aus einem Kunststoffspritzgußteil, an dessen Boden 41 nach unten offene Befestigungsdome 42 angespritzt sind. Der Boden 41 weist ferner einen größeren Durchbruch 43 auf, durch den ein mit der Kühlplatte 44 verbundenes Wärmeleitblech 45 geführt ist. Das die Steckvorrichtungen 46 tragende Abdeckteil 47 ist hier gleichfalls ein Kunststoffspritzgußteil, das in Kammern 48 die Kontaktfedern 49 der Steckbuchsen für die Ein/Ausgangsmodule haltert. Das Abdeckteil 47 ist über Schraubverbindungen 50 in den Befestigungsdomen 42 mit dem Gehäuse 40 verschraubt. Die wasserdichte Abdichtung wird durch umlaufende Gummiringe 51 oder Weichgummiplatten 52 sichergestellt.

Unter dem Abdeckteil 47 ist eine Leiterplatte 53 vorgesehen, in die alle Anschlüsse der Steckverbindungen eingelötet sind und über die die Weiterverbindung erfolgt. Über Haltebolzen 54 mit Abstandsstücken 55 sind weitere Platten im Abstand montiert, die aus einer Leiterplatte 56 für den Logikbaustein und zwei Abschirmplatten 57 bestehen, welche nach oben und unten die Leiterplatte 56 für den Logikbaustein abdecken. Zur Abschirmung nach außen kann die Innenwand des Gehäuses 40 mit einem Abschirmbelag versehen sein (nicht dargestellt) oder der Spritzguß besteht aus einem elektrisch leitenden Material. Auf dem mit der Kühlplatte 44 verbundenen Wärmeleitblech 45 ist eine weitere Netzteil-Leiterplatte 58 und die Kühlkörper der Leistungshalbleiter 62 dieses Netzteils befestigt.

Je nach den am Einsatzort zu erwartenden Umwelteinflüssen können weitere Vorrichtungen vorgesehen sein, die Schäden durch eindringende Restfeuchtigkeit verhindern. So kann z. B. in einer Kammer des Abdeckteils hygroskopisches Material eingebracht sein, z. B. über einem Durchbruch in der Kühlplatte 44 ein Filter oder ein Ventil angeordnet werden, das den Überdruck entweichen läßt, oder eine direkte Membran vorgesehen sein, die durch Ausdehnung einen Überdruck ausgleicht und/oder auf der Leiterplatte 53 ein Feuchtigkeitssensor angebracht sein, der bei einer Betauung oder zu hoher Feuchtigkeit ein Fehlersignal liefert.

Die elektrische Verbindung zwischen den Leiterplatten kann über Vielfachsteckvorrichtungen erfolgen wie dies zwischen der Leiterplatte 53 zur Anschlußverteilung und der Leiterplatte 56 für den Logikbaustein dargestellt ist, oder es sind flexible Leiterbahnen zwischen den Leiterplatten vorgesehen.

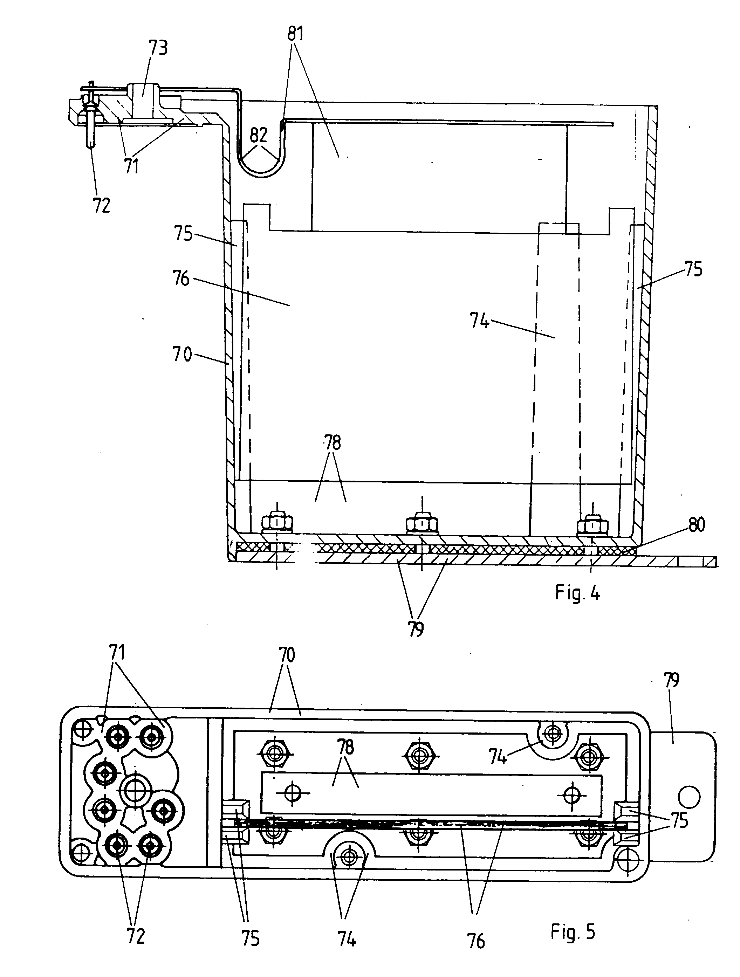

In Fig. 4 und 5 ist ein Ein/Ausgangsmodul im Schnitt und in der Draufsicht ohne obere Abdeckung (14 in Fig. 2) dargestellt. Auch hier besteht das Gehäuse 70 aus einem an der Gehäuseinnenwand mit einer metallischen Abschirmung versehenem Kunststoffspritzgußteil, das am oberen Ende eine aus einer Schmalseite herausragende Verlängerung 71 aufweist. In dieser Verlängerung 71 sind die Anschlußsteckerstifte 72 zum Einstecken in den Steckverteilerkasten (1 in Fig. 1) befestigt und ein Durchbruch 73 für die Befestigungsschraube (16 in Fig. 1) vorgesehen. Verlängerung 71 und Anschlußsteckerstifte 72 bilden damit eine Steckvorrichtung, welche Ein/Ausgangsmodule 2 und Steckverteilerkasten 1 mechanisch und elektrisch verbindet.

Das Gehäuse weist auf jeder Breitseite einen nach außen offenen Befestigungsdom 74 auf, der zur Befestigung der oberen Abdeckung (14 in Fig. 2) dient. An der Innenwand des Gehäuses 70 sind an den Schmalseiten je zwei Stege 75 angespritzt, zwischen denen eine Leiterplatte 76 eingeschoben ist. Auf dieser Leiterplatte 76 befinden sich die elektronischen Schaltungen für die Verstärkung, Anpassung und/oder Anzeige der Ein/Ausgangssignale. Die Leistungs-Endstufen für die vier Ein/Ausgänge sind wärmeleitend mit einem Wärmeleitblech 78 verbunden, das durch einen Durchbruch im Gehäuseboden mit der dort verschraubten Kühlplatte 79 verbunden ist. Die Abdichtung nach außen erfolgt auch hier über eine Weichgummiplatte 80. Die elektrische Verbindung der Bauelemente auf der Leiterplatte 76 mit den Anschlußsteckern 72 und den Anschlußbuchsen auf der oberen Abdeckung (14 in Fig. 2) erfolgt über Leitungen auf einer flexiblen Leiterbahn 81, in der die Anschlüsse eingelötet sind und die zur leichteren Montage in Schlaufen 82 geführt ist. Die Anzeige kann hierbei über LEDs erfolgen, die wie die Anschlüsse für die Steckbuchsen (21 in Fig. 1) auf der flexiblen Leiterplatte angelötet und durch in Fig. 1 dargestellte Durchbrüche 63 zu erkennen, nach außen durchsichtig und wasserdicht abgeschlossen sind.

Die Gehäuse 70 sind zweckmäßig so ausgebildet, daß mehrere, zum Beispiel vier Ein/Ausgangsmodule 2 nebeneinander an einer oder zwei Seiten des Steckverteilerkastens 1 einsteckbar sind.

Durch den besonderen Aufbau wird es möglich, die Ein/Ausgangsmodule (2) leicht zu installieren, zu prüfen und/oder auszutauschen. Oft wird es erforderlich, die Ein/Ausgangsstufen bezüglich ihrer Leistung, Strom oder Spannung an die MeldeStell- oder Meßglieder der Anlage anzupassen. So können im Innern unterschiedlich aufgebaute Ein/Ausgangsstufen ausgewählt und entsprechend zusammengestellt am steckverteilerkasten (1) angeschlossen werden, d. h. es wird ein einfacher modularer Aufbau möglich.

An sich besteht die Möglichkeit, die einzelnen Stufen derart aufzubauen, daß sie sich sowohl als Eingangs- oder auch als Ausgangsstufen verwenden lassen. Hierzu wird jedoch ein zusätzlicher Schaltungsaufwand erforderlich und/oder die Stufen lassen sich nicht optimal auslegen. Bei der erfindungsgemäßen Ein/Ausgabebaugruppe ist eine derartige Doppelverwendung nicht erforderlich, da hier durch die Auswahl der Moduln die erforderliche Anzahl an Ein- oder Ausgangsstufen weitgehend frei gewählt werden kann. Beispielsweise können die Ein/Ausgangsmodule 2 aus Modulen zusammengestellt sein, die entweder mehrere, z. B. vier Eingangsstufen, und/oder mehrere, z. B. vier Ausgangsstufen aufweisen. Zur besseren Anpassung an die jeweilige Zahl der Ein- oder Ausgänge können auch Module zur Auswahl stehen, die je zur einen Hälfte Eingangs- und zur anderen Hälfte Ausgangsstufen, z. B. zwei Ein- und zwei Ausgangsstufen, enthalten.

Bei einigen Anlagen oder Maschinen wird auch die Verarbeitung von analogen Signalen erforderlich. Hierzu können Module vorgesehen sein, die analoge Eingangssignale verarbeiten, d. h. bei vorgegebenen oder einstellbaren Signalpegeln entsprechende digitale Signale weitergeben oder die analogen Eingangssignale werden in einem Digital/Analogwandler in digitale Werte umgewandelt über den Signalbus an die Steuerung gegeben. In ähnlicher Weise können auch Ausgangsmodule so aufgebaut sein, daß sie digitale Signale in analoge Werte umwandeln und diese z. B. zu Steuerungszwecken an die Maschine bzw. Anlage weitergeben.

Ebenso ist es möglich, die Ein/Ausgangsmodule 2 in Fluid-Technik, Glasfasertechnik, Pneumatik oder einer beliebigen anderen Technik auszuführen.

Durch die Möglichkeit, eine Diagnoseeinrichtung direkt am Steckverteilerkasten anschließen zu können, kann im Fehlerfall eine weitergehende Diagnose durchgeführt werden, die mit Hilfe des Logikbausteines eine Fehlerermittlung bis hin zu den einzelnen Melde-, Stell- oder Meßgliedern ermöglicht. Zur leichteren Ermittlung der einzelnen Steckverbindungen können neben diesen in den oberen Abdeckungen 4, 14, 47 Schlitze 33 vorgesehen werden, in die sich von der Seite her Bezeichnungsschilder 34 festklemmend einschieben lassen.

## Patentansprüche

1. Dezentrale Ein-/Ausgabebaugruppe, die über eine Busleitung zur Übertragung von Ein-/Ausgangssignalen mit einer elektronischen Steuerung verbunden und räumlich getrennt von dieser angeordnet ist, gekennzeichnet durch
- ein oder mehrere steckbare Ein-/Ausgangsmodule (2) mit gleich- oder verschiedenartig aufgebauten Ein-/Ausgangsstufen,
- einen Steckverteilerkasten (1), der
- einen Steckanschluß (8) für die Busleitung sowie
- mehrere Steckanschlüsse (12) für Ein-/Ausgangsmodule (2) und
- einen den Austausch von Signalen zwischen der Steuerung und den Ein-/Ausgangsstufen sowie deren Verteilung steuernden Logikbaustein aufweist,
wobei der Steckverteilerkasten (1) und die Ein-/Ausgangsmodule (2) einschließlich aller Steckverbindungen staub- und/oder wasserdicht ausgebildet sind.

2. Ein/Ausgabebaugruppe nach Anspruch 1, dadurch gekenneichnet, daß der Steckverteilerkasten (1) eine weitere Steckverbindung (7) für die Stromversorgung des Logikbausteins sowie der Ein/Ausgangsmodule (2) über deren Sterkverbindungen aufweist.

3. Ein/Ausgabebaugruppe nach einem der Ansprüche 1 oder 2, dadurch gekennzeichnet, daß der Steckverteilerkasten (1) eine obere Abdeckplatte (4) aufweist, in der alle Steckanschlüsse (7,8,9,12) angeordnet sind und das Einstecken der Steckvorrichtungen in diese Steckanschlüsse (7,8,9,12) von oben erfolgt.

4. Ein/Ausgabebaugruppe nach einem der Ansprüche 1 bis 3, dadurch gekennzeichnet, daß der Steckverteilerkasten (1) eine obere Abdeckplatte (4) aufweist in der an zumindest einem Außenrand eine Reihe gleichartiger Steckvorrichtungen (12,46) für die Ein/Ausgangsmodule (2) vorgesehen sind.

5. Ein/Ausgabebaugruppe nach einem der Ansprüche 1 bis 4, dadurch gekennzeichnet, daß im mittlerem Teil der oberen Abdeckplatte (4,47) des Steckverteilerkastens (1) zwei Steckanschlüsse (8) für Busleitungen vorgesehen sind, wobei der eine Steckanschluß zur Weiterverteilung des Signalbusses dient.

6. Ein/Ausgabebaugruppe nach einem der Ansprüche 1 bis 5, dadurch gekennzeichnet, daß im mittlerem Teil der oberen Abdeckplatte (4,47) des Steckverteilerkastens (1) eine Steckvorrichtung (9) für eine Diagnosevorrichtung vorgesehen ist.

7. Ein/Ausgabebaugruppe nach einem der Ansprüche 1 bis 6, dadurch gekennzeichnet, daß im mittleren Teil der oberen Abdeckplatte (4,47) des Steckverteilerkastens (1) eine Anzeigevorrichtung (11) für die Adresse der jeweiligen Ein- oder Ausgangsstufe und/oder des Status für diesen Ein/Ausgang vorgesehen ist.

8. Ein/Ausgabebaugruppe nach einem der Ansprüche 1 bis 7, dadurch gekennzeichnet, daß im Steckverteilerkasten (1) parallel zur oberen Abdeckplatte (47) eine Leiterplatte (53) vorgesehen ist, in der Anschlüsse (49) für die auf der Abdeckplatte (47) befestigten Steckvorrichtungen (46) und eine innere Vielfachsteckvorrichtung für einen Logikbaustein eingelötet sind.

9. Ein/Ausgabebaugruppe nach einem der Ansprüche 2 bis 8, dadurch gekennzeichnet, daß im Steckverteilerkasten (1) parallel zur oberen Abdeckplatte (47) eine Leiterplatte (56) vorgesehen ist, auf der die Bauelemente des Logikbausteins angeordnet sind.

10. Ein/Ausgabebaugruppe nach Anspruch 9, dadurch gekennzeichnet, daß im Steckverteilerkasten (1) oberhalb und/oder unterhalb der Leiterplatte (56) für den Logikbaustein eine Abschirmplatte (57) vorgesehen ist.

11. Ein/Ausgabebaugruppe nach einem der Ansprüche 1 bis 10, dadurch gekennzeichnet, daß im unteren Teil des Steckverteilerkasten (1) die Bauelemente für die Stromversorgung untergebracht sind, und die Leistungsteile (62) der Stromversorgung wärmeleitend mit einem Kühlkörper (44) verbunden sind, der als Teil des Bodens (41) des Steckverteilerkastens (1) ausgebildet ist, oder aus dem Boden des Steckverteilerkastens herausragt.

12. Ein/Ausgabebaugruppe nach einem der Ansprüche 1 bis 11, dadurch gekennzeichnet, daß die Ein/Ausgangsmodule (2) außerhalb des Steckverteilerkastens (1) angeordnet und über eine Steckvorrichtung mechanisch und elektrisch mit dem Steckverteilerkasten bzw. den entsprechenden elektrischen Anschlüssen im Steckverteilerkasten (1) verbunden sind.

13. Ein/Ausgabebaugruppe nach einem der Ansprüche 1 bis 12, dadurch gekennzeichnet, daß die Ein/Ausgangsmodule (2) eine obere Abdeckung (14) aufweisen, in der eine Reihe Steckerbuchsen (21) vorgesehen sind, die dem Anschluß der an der Maschine oder Anlage verteilten Melde-, Stell- oder Meßgliedern dienen.

14. Ein/Ausgabebaugruppe nach einem der Ansprüche 1 bis 13, dadurch gekennzeichnet, daß die Ein/Ausgangsmodule (2) schmale Gehäuse (70) aufweisen aus deren Schmalseite eine seitliche Verlängerung (35,71) herausragt, auf deren Unterseite Steckerstifte (72) für die elektrische Verbindung zum Steckverteilerkasten (1) angeordnet sind und durch die eine Schraubverbindung (16) geführt ist, die der mechanischen Befestigung am Steckerverteilerkasten (1) dient.

15. Ein/Ausgabebaugruppe nach einem der Ansprüche 1 bis 14, dadurch gekennzeichnet, daß die Gehäuse (70) der einzelnen Ein/Ausgangsmodule (2) derart ausgebildet sind, daß mehrere Ein/Ausgangsmodule (2) nebeneinander an einer oder zwei Seiten des Steckverteilerkastens (1) einsteckbar sind.

16. Ein/Ausgabebaugruppe nach einem der Ansprüche 1 bis 15, dadurch gekennzeichnet, daß die in den Steckverteilerkasten (1) eingesteckten Ein/Ausgangsmodule (2) aus einer Reihe unterschiedlich aufgebauter Ein/Ausgangsmodule z.B bezüglich der Ausgangsleistung oder sonstiger Anpassungen und/oder ihrer Anzahl entsprechend den Anforderungen der Maschine oder Anlage ausgewählt sind.

17. Ein/Ausgabebaugruppe nach Anspruch 16, dadurch gekennzeichnet, daß Ein/Ausgangsmodule (2) mit Ein- oder Ausgänge in einer anderen Technik, wie Fluid-Technik, Glasfasertechnik oder Pneumatik aufgebaut sind.

18. Ein/Ausgabebaugruppe nach einem der Ansprüche 1 bis 17, dadurch gekennzeichnet, daß der Steckverteilerkasten (1) auf einem Montagerahmen (30) oder einer Montageplatte befestigt ist, die seitliche Befestigungsflächen aufweist die sich unterhalb der eingesteckten Ein/Ausgangsmodule erstrecken und der zusätzlichen Befestigung (29) dieser Ein/Ausgangsmodule (2) dienen.

19. Ein/Ausgabebaugruppe nach einem der Ansprüche 1 bis 18, dadurch gekennzeichnet, daß die Steckverbindungen (7,8,9,21) für die Außenanschlüsse des Steckverteilerkastens (1) und der eingesteckten Ein/Ausgangsmodule (2) annähernd in einer Ebene liegen, und daß neben den Steckverbindungen Halterungen, insbesondere Einschiebschlitze (33) für auswechselbare Bezeichnungsschilder (34) vorgesehen sind.

20. Ein/Ausgabebaugruppe nach einem der Ansprüche 1 bis 19, dadurch gekennzeichnet, daß die Steckvorrichtungen mit Dichtungen versehen sind, die ein Abdichten mit und ohne Steckverbindung ermöglichen, insbesondere Kappen (18,22) vorgesehen sind mit denen nichtbenutzte Steckvorrichtungen verschraubbar oder festklemmend abzudichten sind.

21. Ein/Ausgabebaugruppe nach einem der Ansprüche 1 bis 20, dadurch gekennzeichnet, daß im Gehäuse (40) des Steckverteilerkastens (1) und/oder der Ein/Ausgangsmodule (2) ein Feuchtigkeitssensor vorgesehen ist, der bei erhöhter Feuchtigkeit oder Betauung ein Fehlersignal erzeugt.

22. Ein/Ausgabebaugruppe nach einem der Ansprüche 1 bis 21, dadurch gekennzeichnet, daß die Zusammenstellung der Ein/Ausgangsmodule (2) durch eine Auswahl von Modulen erfolgt, die entweder mehrere Eingangs- oder mehrere Ausgangsstufen enthalten.

23. Ein/Ausgabebaugruppe nach Anspruch 22, dadurch gekennzeichnet, daß einzelne Module zur Auswahl stehen die zur Hälfte Eingangsstufen und zur anderen Hälfte Ausgangsstufen enthalten.

24. Ein/Ausgabebaugruppe nach einem der Ansprüche 22 oder 23, dadurch gekennzeichnet, daß einzelne Module zur Auswahl stehen, die analoge Eingangssignale verarbeiten, insbesondere einen Signalpegel bzw. einen Schwellwert erfassen, oder die Eingangssignale über einen Analog/ Digitalwandler in digitale Werte umwandeln.

25. Ein/Ausgabebaugruppe nach einem der Ansprüche 22 bis 24, dadurch gekennzeichnet, daß einzelne Module zur Auswahl stehen, die digitale Ausgangssignale verarbeiten, insbesondere über einen Digital/Analogwandler in analoge Steuerspannungen umwandeln.

26. Ein/Ausgabebaugruppe nach einem der Ansprüch 1 bis 25, dadurch gekennzeichnet, daß im Steckverteilerkasten (1) zwei Steckanschlüsse (8) für Busverbindungen vorgesehen sind, die der Zwischenschaltung der Ein/Ausgabebaugruppe in eine Ringleitung für Busverbindungen anderer Ein/Ausgabebaugruppen dienen.

## Claims

1. Decentralised input/output assembly which is connected via a bus line for the transmission of input/ output signals to an electronic control and is arranged spatially separated therefrom, characterized by
- one or more pluggable input/output modules (2) with the input/output stages which are of identical or different design,
- a push-on plug distributor box (1) which has
- a plug-type terminal (8) for the bus line and
- a plurality of plug-type terminals (12) for input/output modules (2) and
- a logic module which controls the exchange of signals between the control and the input/output stages and the distribution of the said signals,
the push-on plug distributor box (1) and the input/output modules (2), including all the plug-type connections being realised in a dustproof and/or watertight fashion.

2. Input/output assembly according to Claim 1, characterized in that the push-on plug distributor box (1) has a further plug-type connection (7) for supplying power to the logic module and to the input/output modules (2) via their plug-type connections.

3. Input/output assembly according to one of Claims 1 or 2, characterized in that the push-on plug distributor box (1) has an upper cover plate (4) in which all the plug-type terminals (7, 8, 9, 12) are arranged, and the plugging-in of the plug devices into these plug-type terminals (7, 8, 9, 12) takes place from above.

4. Input/output assembly according to one of Claims 1 to 3, characterized in that the push-on plug distributor box (1) has an upper cover plate (4) in which a series of identical plug devices (12, 46) for the input/output modules (2) are provided at at least one outer edge.

5. Input/output assembly according to one of Claims 1 to 4, characterized in that two plug-type terminals (8) for bus lines are provided in the centre part of the upper cover plate (4, 47), one of the plug-type terminals serving to distribute the signal bus further.

6. Input/output assembly according to one of Claims 1 to 5, characterized in that a plug device (9) for a diagnostic device is provided in the centre part of the upper cover plate (4, 47) of the plug-type distributor box (1).

7. Input/output assembly according to one of Claims 1 to 6, characterized in that a display device (11) for addressing the respective input or output stage and/or the status of this input/output is provided in the centre part of the upper cover plate (4, 47).

8. Input/output assembly according to one of Claims 1 to 7, characterized in that a printed circuit board (53), into which terminals (49) for the plug devices (46) which are attached to the cover plate (47) and an inner multiple plug device for a logic module are soldered, is provided in the push-on plug distributor box (1) parallel to the upper cover plate (47).

9. Input/output assembly according to one of Claims 2 to 8, characterized in that a printed circuit board (56) on which the components of the logic module are arranged is provided in the push-on plug distributor box (1) parallel to the upper cover plate (47).

10. Input/output assembly according to Claim 9, characterized in that a screen plate (57) is provided in the push-on distributor box (1) above and/or below the printed circuit board (56) for the logic module.

11. Input/output assembly according to one of Claims 1 to 10, characterized in that the components for the power supply are accommodated in the lower part of the push-on plug distributor box (1) and the power circuits (62) of the power supply are connected in a heat-conducting fashion to a heat sink (44) which is realized as part of the base (41) of the push-on plug distributor box (1) or projects out of the base of the push-on plug distributor box.

12. Input/output assembly according to one of Claims 1 to 11, characterized in that the input/output modules (2) are arranged outside the push-on plug distributor box (1) and are mechanically and electrically connected to the push-on plug distributor box and/or the corresponding electrical terminals in the push-on plug distributor box (1) via a plug device.

13. Input/output assembly according to one of Claims 1 to 12, characterized in that the input/output modules (2) have an upper cover (14) in which a series of sockets (21), which serve for the connection of the signalling elements, actuator elements or measuring elements which are distributed to the machine or equipment, is provided.

14. Input/output assembly according to one of Claims 1 to 13, characterized in that the input/output modules (2) have narrow housings (70) from whose narrow side a lateral extension (35, 71) extends, on the underside of which extension (35, 71) plug pins (72) for the electrical connection to the push-on plug distributor box (1) are arranged and through which a screwed connection (16), which serves for the mechanical attachment to the push-on plug distributor box (1), is led.

15. Input/output assembly according to one of Claims 1 to 14, characterized in that the housings (70) of the individual input/output modules (2) are realized in such a way that a plurality of input/output modules (2) can be plugged in one next to the other on one or two sides of the push-on plug distributor box (1).

16. Input/output assembly according to one of Claims 1 to 15, characterized in that the input/output modules (2) which are plugged into the push-on plug distributor box (1) are selected from a series of input/output modules which are of different designs, for example with regard to the output power or other adaptations and/or their number, depending on the requirements of the machine or equipment.

17. Input/output assembly according to Claim 16, characterized in that input/output modules (2) are constructed with input or outputs using different technology, such as fluid technology, optical-fibre technology or pneumatics.

18. Input/output assembly according to one of Claims 1 to 17, characterized in that the push-on plug distributor box (1) is attached to a mounting frame (30) or a mounting plate which has lateral attachment surfaces which extend underneath the plugged-in input/output modules and serve for the additional attachment (29) of these input/output modules (2).

19. Input/output assembly according to one of Claims 1 to 18, characterized in that the plug-type connections (7, 8, 9, 21) for the external terminals of the push-on plug distributor box (1) and of the plugged-in input/output modules (2) lie approximately in one plane, and in that, in addition to the plug-type connections, securing means, in particular insertion slots (33) for interchangeable labelling plates (34) are provided.

20. Input/output assembly according to one of Claims 1 to 19, characterized in that the plug devices are provided with seals which make possible a seal with and without plug-type connection, and in particular caps (18, 22) are provided with which non-used plug devices are to be sealed in a screwable or securely clamping fashion.

21. Input/output assembly according to one of Claims 1 to 20, characterized in that a moisture sensor, which produces a fault signal when the moisture or condensation is high, is provided in the housing (40) of the push-on plug distributor box (1) and/or of the input/output modules (2).

22. Input/output assembly according to one of Claims 1 to 21, characterized in that the input/output modules (2) are assembled by means of a selection of modules which contain either a plurality of input stages or a plurality of output stages.

23. Input/output assembly according to Claim 22, characterized in that individual modules, whose one half contains input stages and whose other half contains output stages, are available for selection.

24. Input/output assembly according to one of Claims 22 and 23, characterized in that individual modules which process input signals, in particular detect a signal level or a threshold value or convert the input signals into digital values by means of an analog/digital converter, are available for selection.

25. Input/output assembly according to one of Claims 22 to 24, characterized in that individual modules which process digital output signals, in particular convert them into analog control voltages by means of a digital/analog converter, are available for selection.

26. Input/output assembly according to one of Claims 1 to 25, characterized in that two plug-type terminals (8) for bus connections are provided in the push-on plug distributor box (1), which bus connections serve for the insertion of the input/output assembly into a ring circuit for bus connections of other input/output assemblies.

## Revendications

1. Unité entrée/sortie décentralisée reliée par un bus pour la transmission de signaux entrée-sortie à une commande électronique en étant distante de celle-ci,
caractérisée par :
- un ou plusieurs modules entrée/sortie (2), enfichables, ayant des étages entrée/sortie de construction analogue ou différente,
- un boîtier de connexion-distribution (1) qui comprend :
- un branchement de connexion (8) pour le bus ainsi que
- plusieurs branchements de connexion (12) pour les modules entrée/sortie (2), et
- un composant logique qui commande l'échange des signaux entre la commande et les étages entrée/sortie, ainsi que leur distribution,
le boîtier de connexion-distribution (1) et les modules entrée/sortie (2) y compris toutes les connexions sont étanches à la poussière et/ou à l'eau.

2. Unité entrée/sortie selon la revendication 1,
caractérisée en ce que
le boîtier de connexion-distribution (1) comporte une autre liaison par connexion (7) pour l'alimentation électrique du composant logique ainsi que des modules entrée/sortie (2) par leur liaison de connexion.

3. Unité entrée/sortie selon l'une des revendications 1 ou 2,
caractérisée en ce que
le boîtier de connexion-distribution (1) comporte une ou plusieurs plaques formant des couvercles (4) munies de tous les moyens de connexion (7, 8, 9, 12) et l'enfichage des dispositifs de connexion dans ces branchements de connexion (7, 8, 9, 12) se fait par le dessus.

4. Unité entrée/sortie selon l'une des revendications 1 à 3,
caractérisée en ce que
le boîtier de connexion-distribution (1) comporte un couvercle supérieur (4) muni au moins au niveau d'un bord extérieur, d'une série de dispositifs de connexion (12, 46) de même type pour un module entrée/sortie (2).

5. Unité entrée/sortie selon l'une des revendications 1 à 4,
caractérisée en ce que
dans la partie médiane du couvercle (4) du boîtier de connexion-distribution (1), il y a deux branchements de connexion (8) pour des bus, l'un des branchements de connexion servant à la distribution du bus.

6. Unité entrée/sortie selon l'une des revendications 1 à 5,
caractérisée en ce que
dans la partie médiane du couvercle (4) du boîtier de connexion-distribution (1), il est prévu un dispositif de connexion (9) pour un dispositif de diagnostic.

7. Unité entrée/sortie selon l'une des revendications 1 à 6,
caractérisée en ce que
dans la partie médiane du couvercle (4) du boîtier de connexion-distribution (1), il est prévu un dispositif d'affichage (11) pour l'adresse des différents étages entrée/sortie et/ou de l'état de ces entrées/sorties.

8. Unité entrée/sortie selon l'une des revendications 1 à 7,
caractérisée en ce que
dans le boîtier de connexion-distribution (1), parallèlement au couvercle supérieur (47), il est prévu une plaque de circuit imprimé (53) munie des branchements (49) pour les dispositifs de connexion (46) fixés au couvercle (47) et un dispositif de connexion multiple intérieur y est soudé pour un circuit logique.

9. Unité entrée/sortie selon l'une des revendications 2 à 8,
caractérisée en ce que
dans le boîtier de connexion-distribution (1) parallèlement au couvercle supérieur (47) se trouve une plaque de circuit imprimé (56) qui porte les composants du circuit logique.

10. Unité entrée/sortie selon la revendication 9,
caractérisée en ce que
une plaque formant écran (57) se trouve dans le boîtier de connexion-distribution (1) au-dessus et/ou en dessous de la plaque de circuit imprimé (56) du circuit logique.

11. Unité entrée/sortie selon l'une des revendications 1 à 10,
caractérisée en ce que
dans la partie inférieure du boîtier de connexion-distribution (1) sont logés les composants de l'alimentation électrique et les éléments de puissance (62) de l'alimentation électrique sont reliés à un radiateur (44) par la liaison conductrice de chaleur, ce radiateur constituant une partie du fond (41) du boîtier de connexion-distribution (1) ou encore il sort du fond du boîtier de connexion-distribution.

12. Unité entrée/sortie selon l'une des revendications 1 à 11,
caractérisée en ce que
les modules entrée/sortie (2) sont prévus à l'extérieur du boîtier de connexion-distribution (1) et sont reliés par un dispositif d'enfichage, mécaniquement, électriquement au boîtier de connexion-distribution ou à des branchements électriques correspondants du boîtier de connexion-distribution (1).

13. Unité entrée/sortie selon l'une des revendications 1 à 12,
caractérisée en ce que
les modules entrée/sortie (2) comportent un couvercle supérieur (14) muni d'une rangée de douilles de connexion (21) servant aux branchements des éléments de signalisation, de réglage ou de mesure de la machine ou de l'installation.

14. Unité entrée/sortie selon l'une des revendications 1 à 13,
caractérisée en ce que
les modules entrée/sortie (2) comportent des boîtiers (70) étroits avec des petits côtés munis d'un prolongement latéral (35, 71) dont la face inférieure comporte une broche de connexion (72) pour la liaison électrique avec le boîtier de connexion-distribution (1) et qui sont traversés par une liaison à vis (16) servant à la fixation mécanique sur le boîtier de connexion-distribution (1).

15. Unité entrée/sortie selon l'une des revendications 1 à 14,
caractérisée en ce que
les boîtiers (70) des différents modules entrée/sortie (2) sont réalisés pour permettre d'enficher plusieurs modules entrée/sortie (2), l'un à côté de l'autre sur un ou deux côtés du boîtier de connexion-distribution (1).

16. Unité entrée/sortie selon l'une des revendications 1 à 15,
caractérisée en ce que
les modules entrée/sortie (2) enfichés dans le boîtier de connexion-distribution (1) se composent d'une série de modules entrée/sortie de construction différente par exemple du point de vue de leur puissance de sortie ou autres adaptations et/ou de leur nombre, en fonction des nécessités de la machine ou de l'installation.

17. Unité entrée/sortie selon la revendication 16,
caractérisée en ce que
un module entrée/sortie (2) est réalisé avec une entrée ou une sortie dans une autre technique telle que la technique fluidique, la technique des fibres de verre ou la technique pneumatique.

18. Unité entrée/sortie selon l'une des revendications 1 à 17,
caractérisée en ce que
le boîtier de connexion-distribution (1) est fixé sur un châssis de montage (30) ou une plaque de montage ayant des surfaces de fixation latérales qui s'étendent en dessous des modules entrée/sortie, enfichés et servent à la fixation complémentaire (29) de ces modules entrée/sortie (2).

19. Unité entrée/sortie selon l'une des revendications 1 à 18,
caractérisée en ce que
les moyens de connexion (7, 8, 9, 21) des branchements extérieurs du boîtier de connexion-distribution (1) et des modules entrée/sortie (2) enfichés, se situent pratiquement dans un plan et à côté des liaisons par enfichage, il y a des moyens de fixation notamment des fentes (33) pour recevoir des plaquettes d'identification (34) interchangeables.

20. Unité entrée/sortie selon l'une des revendications 1 à 19,
caractérisée en ce que
les dispositifs de connexion sont munis de joints permettant d'assurer l'étanchéité avec ou sans connexions notamment des capuchons (18, 22) qui se vissent ou se montent par serrage, pour rendre étanches les dispositifs de connexion non utilisés.

21. Unité entrée/sortie selon l'une des revendications 1 à 20,
caractérisée en ce que
dans le boîtier (40) du boîtier de connexion-distribution (1) et/ou du module entrée/sortie (2), il y a un capteur d'humidité qui génère un signal de défaut en cas de forte humidité ou de condensation.

22. Unité entrée/sortie selon l'une des revendications 1 à 21,
caractérisée en ce que
la composition des modules entrée/sortie (2) se fait par le choix des modules qui comportent soit plusieurs étages d'entrée, soit plusieurs étages de sortie.

23. Unité entrée/sortie selon la revendication 22,
caractérisée en ce que
l'on dispose de différents modules qui comportent par moitié des étages d'entrée et pour l'autre moitié des étages de sortie.

24. Unité entrée/sortie selon la revendication 22 ou 23,
caractérisée en ce que
l'on dispose de différents modules au choix qui traitent des signaux d'entrée analogiques en particulier à un niveau de signal ou un seuil et convertissent les signaux d'entrée en signaux numériques par un convertisseur analogique/numérique.

25. Unité entrée/sortie selon l'une des revendications 22 à 24,
caractérisée en ce que
on dispose de différents modules qui traitent les signaux de sortie numériques en particulier par un convertisseur numérique/analogique pour donner des tensions de commande analogiques.

26. Unité entrée/sortie selon l'une des revendications 1 à 25,
caractérisée par
deux branchements de connexion (8) dans le boîtier de connexion-distribution (1) pour des bus qui servent à brancher de manière intermédiaire l'unité entrée/sortie dans une ligne en boucle pour des bus d'autres unités entrée/sortie.
